## Europäisches Patentamt
## European Patent Office
## Office européen des brevets

(19)

(11) Veröffentlichungsnummer: **0 156 014**
**B1**

(12)

# EUROPÄISCHE PATENTSCHRIFT

(45) Veröffentlichungstag der Patentschrift: **29.08.90**

(21) Anmeldenummer: **84115187.1**

(22) Anmeldetag: **12.12.84**

(51) Int. Cl.⁵: **H 01 S 3/19, H 01 S 3/23**

(54) Laserdioden-Array.

(30) Priorität: **27.03.84 DE 3411314**

(43) Veröffentlichungstag der Anmeldung:
**02.10.85 Patentblatt 85/40**

(45) Bekanntmachung des Hinweises auf die
Patenterteilung:
**29.08.90 Patentblatt 90/35**

(84) Benannte Vertragsstaaten:
**DE FR GB IT**

(56) Entgegenhaltungen:
US-A-3 531 735
US-A-4 318 058

IBM TECHNICAL DISCLOSURE BULLETIN, Band
15, Nr. 7, Dezember 1972, Seite 2345, New York,
US; J.M. BLUM et al.: "Double heterojunction
laser arrays"
IBM TECHNICAL DISCLOSURE BULLETIN, Band
18, Nr. 10, März 1976, Seiten 3497-3498, New
York, US; P.S. ZORY: "Continuous wave laser
array"

(73) Patentinhaber: **Siemens Aktiengesellschaft
Wittelsbacherplatz 2
D-8000 München 2 (DE)**

(72) Erfinder: **Heinen, Jochen, Dr.
Dianastrasse 38
D-8013 Haar (DE)**
Erfinder: **Kappeler, Franz, Dr.
Narzissenstrasse 4
D-8039 Puchheim (DE)**
Erfinder: **Westermeier, Heinz
Jos.-Kyreinstrasse 9c
D-8014 Neubiberg (DE)**

(56) Entgegenhaltungen:
PATENTS ABSTRACTS OF JAPAN, Band 7, Nr.
284 (E-217)1429r, 17. Dezember 1983; & JP-A-58
161 390

**Beschreibung**

Die vorliegende Erfindung bezieht sich auf ein Laserdioden-Array, wie es im Oberbegriff des Patentanspruchs 1 angegeben ist.

Es ist bekannt, eine Vielzahl streifenförmiger Laserdioden nebeneinander verlaufend in einem Halbleiterkörper anzuordnen. Die jeweilige Lage der einzelnen Laserdiodenstreifen im Halbleiterkörper ist durch verschiedenartige Maßnahmen bestimmbar, so z.B. durch parallelverlaufende Oxidstreifen (Oxidstreifenlaser), durch parallelverlaufende Wellenführungsstreifen, durch parallelverlaufende hochohmige Streifenzonen und dgl. Derartige hochohmige Streifenzonen sind in der DE—PS 14 39 316 zu einem mehrere Laserdiodenstreifen enthaltenden Halbleiterdiodenkörper beschrieben, wobei dort die Aufteilung in Laserdiodenstreifen zum Zwecke einer verbesserten Kühlung vorgeschlagen worden ist.

Außer Streifen-Diodenlaser sind auch solche Laserdioden bekannt, die einen flächenmäßigen pn-Übergang in einem Halbleiterkörper haben.

Es ist bekannte, (DT—AS 11 56 506) daß zwischen benachbarten laseraktiven Bereichen in einem Halbleiterkörper optische Kopplung auftreten kann, mit dem Ergebnis, daß eine Korrelation zwischen den in zwei derartigen laseraktiven Zonen erzeugten Laserstrahlungen auftritt. Dies beruht auf einem Überlappen der Ausläufer der jeweiligen Wirkungsbereiche der betreffenden laseraktiven Zonen, und zwar auch über Bereiche des Halbleiterkörpers hinweg, in denen die Bedingungen für das Auftreten stimulierter Emission bzw. das Vorhandensein einer Umbesetzung aus jeweiligen Gründen nicht gegeben ist, z.B. weil dort der Schwellenstromwert für die stimulierte Emission nicht erreicht ist.

Es ist eine Aufgabe der vorliegenden Erfindung, für ein Laserdioden-Array hohe Strahlungsleistung und/oder Verbesserung der Ausbeute an Laserstrahlung hinsichtlich des aufzuwendenden elektrischen Stromes, d.h. höhere Strahlungsausbeute pro aufgewendeter Einheit elektrischer Leistung zu erreichen. Diese Aufgabe wird für ein Laserdioden-Array durch Anwendung der Merkmale des Patentanspruches 1 gelöst und weitere Ausgestaltungen und Weiterbildungen der Erfindung gehen aus den Unteransprüchen hervor.

Die Lehre der Erfindung beruht auf der Erkenntnis, daß bei einem Laserdioden-Array mit einer Vielzahl parallel nebeneinander angeordneten einzelnen Laserdiodenstreifen in von der Emissionsrichtung der gewünschten Laserstrahlung, wobei diese Emissionsrichtung parallel den Laserdiodenstreifen gerichtet ist, abweichenden Richtungen verlaufende, zu einem sehr erheblichen Maß anwachsende Superstrahlung und/oder Laserstrahlung mit unerwünschten Schwingungsmoden auftreten können. Es würde festgestellt, daß solche unerwünschte Strahlung zwar bereits bei einem Array mit nur wenigsten, z.B. 12, 20 oder 30 parallel angeordneten Laserdiodenstreifen auftritt, daß aber bei einem Array mit etwa eine derartige Anzahl überschreitender Anzahl von Laserdiodenstreifen ein solcher Effekt stark überproportional anwachsend ist. Es ergab sich nämlich aus durchgeführten Untersuchungen, daß mit steigender Stromdichte, mit der ein jeweiliges Laserdioden-Array gespeist worden ist, erhebliche Abweichungen von proportionalem Verhalten aufgetreten sind, und zwar unter anderem abhängig von der jeweiligen Anzahl Laserdiodenstreifen, die ein betreffendes untersuchtes Laserdioden-Array umfaßte. Die zunächst zusammenhanglos erscheinenden Ergebnisse führten zu der weiteren Erkenntnis, daß überproportional anwachsende Superstrahlung und/oder Strahlung unerwünschter Schwingungsmoden zu einer Begrenzung maximal erreichbarer Strahlungsleitung und/oder zu einem sehr schlechten Verhältnis zwischen gewünschter (Nutz-)Strahlungsleistung zu aufgewendeter Pumpstromleistung führt.

Gemäß der Erfindung werden für ein Laserdioden-Array die in ihrer Anzahl vorgegebenen Laserdiodenstreifen bzw. die vorhandenen Laserdiodenstreifen zu Gruppen aufgeteilt, wobei eine jeder Gruppe aus einer Anzahl zueinander benachbarter Laserdiodenstreifen besteht. Die jeweilige Anzahl Laserdiodenstreifen in einer betreffenden Gruppe ist auf eine solche Zahl beschränkt, bei der im Bereich der betreffenden Gruppe hinweg Superstrahlung nur in einem noch so beschränkten Ausmaß auftritt und/oder Strahlung mit Schwingungsmoden mit von der gewünschten Emissionsrichtung abweichender Strahlungsrichtung sich noch so wenig ausbilden kann, daß derartige unerwünschte Strahlungen noch verhältnismäßig sehr intensitätsarm verglichen mit der gewolltermaßen emittierten Laserstrahlung ist und/oder noch zu nur so geringem Anteil Pumpstromleistung verzehrt, daß dies für den Betrieb eines Laserdioden-Arrays noch ohne weiteres tragbar ist. Für die jeweilige als Maximum anzusehende Anzahl an Laserdiodenstreifen einer jeweiligen Gruppe läßt sich im Rahmen der Erfindung nicht ohne weiteres ein bestimmter Zahlenwert angeben, da ein derartiger betreffender Zahlenwert auch noch von weiteren Randbedingungen abhängig ist, so vom spezifischen Verstärkungsgrad und von der Höhe der Güte des optischen Resonators sowie auch von der Länge und Breite der Laderdiodenstreifen, der Abstände der Streifen voneinander, des Breite-/Abstandsverhältnisses und davon ob optische Kopplung der Streifen vorliegt oder nicht. Eine solche für die Erfindung in Frage kommende Anzahl kann aber durch praktischen Versuch ermittelt werden, nämlich indem man feststellt, ab einer etwa wie großen Anzahl Laserdiodenstreifen einer Gruppe das vorangehend beschriebene im Rahmen des Entstehens der Erfindung festgestellte unterproportionale bzw. mit starken Gradienten abnehmende weitere Ansteigen der gewünschten Laserstrahlungsleistung bei weiterer Steigerung der elektrischen Pumpstromleistung eintritt.

Da im Regelfall ein Array auf eine derartige bzw. derart ermittelte Anzahl Laserdiodenstreifen einer wie erfindungsgemäß vorgesehenen Gruppe nicht beschränkt werden kann, ist erfindungsgemäß weiter vorgesehen, räumlich zwischen den benachbarten Gruppen (bestehend aus einer jeweiligen Anzahl Laserdiodenstreifen) streifenförmige, sich im wesentlichen parallel zu den Laserdiodenstreifen erstreckende Zonen vorzusehen, die zwei im Halbleiterkörper jeweils benachbart angeordnete Gruppen voneinander trennen, sozusagen benachbarte Gruppen gegeneinander abschotten. Um diese Trennung bzw. dieses Abschotten wirksam werden zu lassen, werden solche Zonen (zwischen benachbarten Gruppen) erzeugt, die Dämpfungseigenschaft für die Laserstrahlung und für die Superstahlung des betreffenden Laserdioden-Arrays haben. Da diese Zonen sich parallel zu den Laserdiodenstreifen erstrecken, wirkt sich ihre dämpfende Eigenschaft wenigstens nicht merkbar nachteilig auf die Laserstrahlungserzeugung in der vorgegebenen Emissionsrichtung auf. Wohl aber wird sowohl Superstrahlung als auch daraus entstehende Laserstrahlung, die von der vorgegebenen Emissionsrichtung abweichende Richtung (im Halbleiter bzw. im Laserdioden-Array) haben, stark gedämpft, sobald sie in eine derartige erfindungsgemäß vorgesehene Zone gelangen.

Insbesondere können gemäß der Erfindung mit den vorgesehenen Zonen solche Laser-Schwingungsmoden gedämpft bzw. verhindert werden, deren Strahlung im Halbleitermaterial des Arrays umlaufenden Strahlungsweg hat, wobei für den Umlauf notwendige Richtungsänderungen auf Totalreflexionen der Strahlung an der Grenzfläche Halbleitermaterial-Luft beruhen. Solche Total reflexion ist bekanntermaßen verlustlos und ein dementsprechender Schwingungsmode (mit Umlauf) hat einen minimalen Wert der Schwellenstromdichte.

Hinsichtlich der erfindungsgemäß vorgesehenen Zonen sei darauf hingewiesen, daß diese zwar für Superstrahlung und unerwünschte Schwingungsmoden stark dämpfende Wirkung haben. Sie schließen aber nicht die optische Kopplung aus, die für ein Laserdioden-Array mit untereinander optisch gekoppelten Laserdiodenstreifen notwendig ist. Es kann hierzu im übrigen vorgesehen sein, daß die sich in Richtung der Laserdiodenstreifen benachbart dem jeweils äußersten Laserdiodenstreifen einer Gruppe erstreckenden erfindungsgemäß vorgesehenen Zonen sich nur über einen für die aufgabengemäße Lösung bereits ausreichenden Längenanteil erstrecken, so daß zum restlichen Längenanteil einander benachbarte bzw. gegenüberstehende Laserdiodenstreifen, die ein jeder zu einem anderen der beiden benachbarten Gruppen gehören, dort durch eine erfindungsgemäß vorgesehene Zone nicht voneinander abgeschottet sind.

Im Regelfall sind Laserdioden-Arrays nebeneinander angeordnete Laserdiodenstreifen, die in einer Fläche, im Regelfall in einer Ebene, des betreffenden Halbleiterkörpers nebeneinander liegend angeordnet sind. Die Anordnung in einer Ebene als derartiger Fläche ist z.B. für die Durchführung von Epitaxie-Verfahrensschritten zur Herstellung eines solchen Arrays besonders bevorzugt.

Es war vorangehend von der Dämpfungseigenschaft der erfindungsgemäß vorgesehenen, die Gruppen voneinander abschottenden Zonen die Rede. Solche Dämpfungseigenschaft kann in verschiedener Weise im Rahmen der Erfindung realisiert sein. Solche Dämpfungseigenschaft kann z.B. optische Streuwirkung für derartige unerwünschte Strahlung im Array sein. Entsprechende Dämpfungswirkung kann auch durch Strahlablenkung für derartige unerwünschte Strahlung bestehen, und zwar Ablenkung in einer Richtung, die derartige Strahlung aus der Fläche (bzw. Ebene) der Anordnung der Laserdiodenstreifen herausführt. Dort außerhalb dieser Ebene kann sogar entstandene Superstrahlung sich nicht weiter verstärken. Eine andere Maßnahme derartige Dämpfungswirkung zu realisieren ist, eine Zone mit ungepumptem Halbleitermaterial vorzusehen, d.h. einen solchen Streifen zwischen benachbarten Gruppen im Halbleiterkörper vorzusehen, in dem keine für Strahlungsverstärkung wirksame Pumpstromdichte vorliegt und stattdessen erzeugte Strahlung absorbiert und in strahlungslose Übergänge umgesetzt wird. Mit in diesem Sinne erhöhter Wirksamkeit sind im Rahmen der Erfindung solche Zonen verwendbar, in denen durch Protonen-Implantation (neben dem Fehlen eines Pumpstromes) strahlungsabsorbierende Zentren hinzugefügt sind, d.h. erhöhtes Absorptionsvermögen für in eine derartige Zone eintretende Super- oder Laserstrahlung vorliegt.

Weitere Erläuterungen der Erfindung gehen anhand der nachfolgenden Beschreibung von Ausführungsbeispielen hervor.

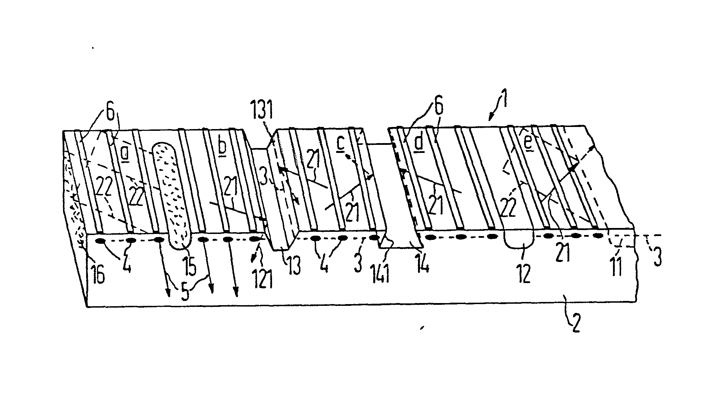

In der beigefügten Figure ist mit 2 ein Halbleiterkörper bezeichnet, in dem im wesentlichen in eine Fläche 3, vorzugsweise in einer Ebene, eine Vielzahl Laserdiodenstreifen 4 vorhanden ist. Von diesen Laserdiodenstreifen 4 ist in der Figur jeweils praktisch nur die Stirnfläche, d.h. die Emissionsfläche des Halbleiterkörpers 2 für die erzeugte Laserstrahlung 5 sichtbar. Im Halbleiterkörper 2 verläuft ein jeweiliger Laserdiodenstreifen 4 in der Fläche 3 unterhalb und entlang eines jeweiligen Elektrodenstreifens 6, über den der notwendige Pumpstrom zugeführt wird. Die sichtbare Stirnfläche und die am anderen Ende des einzelnen Laserdiodenstreifens 4 befindliche, in der Figur nicht sichtbare Stirnfläche des Laserdiodenstreifens 4, weisen für die im Laserdiodenstreifen 4 erzeugte und dort hin- und herverlaufende Laserstrahlung (von der jeweils ein Anteil 5, 5' emittiert wird) ein Reflexionsvermögen auf, das den zugehörigen optischen Resonator bildet.

Gemäß dem einen Merkmal der Erfindung sind die Laserdiodenstreifen des gesamten Arrays 1 in Gruppen, a, b, c, d, e ... aufgeteilt. Der Übersichtlichkeit der Figur halber ist jeweils nur eine sehr kleine Anzahl von Laserdiodenstreifen 4 für eine jede Gruppe a, b, ... dargestellt. In der Praxis sind jeweils bis maximal etwa 10 bis 40 Laserdiodenstreifen in einer Gruppe sinnvoll. Die Anzahl der Gruppen eines erfindungsgemäßen Arrays 1 kann dann dank der Erfindung beliebig groß gewählt werden.

Die Figur zeigt Varianten für Ausführungen von für die Erfindung zu verwendender Zonen 11 bis 16. Ausführungsformen der Erfindung können sowohl eine einzige Variante als auch mehrere der Varianten z.B. gemischt enthalten. Eine solche Variante ist. z.B. ein abschottend wirkender Sperrstreifen 11 des Materials des Halbleiterkörpers. Mit 12 ist eine Variante bezeichnet, bei der ein solcher Sperrstreifen Protonenimplantation zumindest in einer solchen Tiefe des Halbleiterkörpers besitzt, in der die Fläche 3 der Laserdiodenstreifen 4 bzw. die Strahlungsausbreitungsfläche liegt. In zwei Ausführungsformen 13 und 14 ist eine weitere Variante dargestellt, nämlich diejenige, die unerwünschterweise auftretende Superstrahlung und/oder Strahlung unerwünschter Schwingungsmoden, aus der Fläche der Strahlungsausbreitung wegreflektiert bzw. ablenkt. Mit 15 ist die Variante der Erfindung dargestellt, die in einer rinnenartigen Vertiefung des Halbleiterkörpers besteht, wobei die Innenoberfläche der Rinne wenigstens im Bereich der Strahlungsausbreitungsfläche eine für die Strahlung Streuung bewirkende Aufrauhung besitzt. Zur Variante 15 ist die Variante 16 hinzuzurechnen, bei der die Außenseite des Halbleiterkörpers 2 für eine endständige Gruppe von Laserdiodenstreifen zumindest im Bereich der Strahlungsausbreitungsfläche Streuung bewirkende Aufrauhung aufweist.

In dem Bereich der Gruppe 3 ist mit 21 auf Superstrahlung hingewiesen, die zwangsläufig in einem solchen Bereich in der Fläche 3 der Laserdiodenstreifen 4 auftreten kann und in dieser Fläche, die dann die Strahlungsausbreitungsfläche auch für derartige Superstrahlung 21 ist, verläuft. Trifft derartige Superstrahlung 21 auf die Zone 11, erfährt weiter in diese Zone 11 eindringende Strahlung 21 dort keine weitere Verstärkung, sonderen sogar Absorption. Für derartige Strahlung 21 liegt am Übergang in die Zone 11 praktisch auch kein Reflexionsvermögen vor, das nicht nur zu Rückreflexion der Superstrahlung 21, sondern sogar zur Ausbildung insbesondere umlaufender Schwingungsmoden Anlaß geben könnte. Ein solcher andernfalls möglicher Umlauf ist gestrichelt mit 22 (unvollständig) angedeutet. Vorzugsweise befindet sind auf der Oberfläche des Halbleiterkörpers im Bereich der Zone bzw. des Sperrstreifens 11 keine Elektrode da dort Stromzuführung nicht vorzusehen ist. Ist aber aus irgendwelchen Gründen eine z.B. ganzflächige Elektrodenmetallisierung der betreffenden Oberfläche des Halbleiterkörpers 2 vorgesehen, kann eine solche Zone 11 dadurch realisiert sein, daß unterhalb einer solchen flächenmäßigen Metallisierung im oberflächennahen Bereich der Zone 11 (d.h. zwischen der Oberfläche des Halbleiterkörpers 2 und der innen gelegenen Fläche 3 der Laserdiodenstreifen 4) eine elektrisch isolierende Schicht vorgesehen ist. Eine solche elektrisch isolierende Schicht kann z.B. durch entsprechend tiefe Protonenimplantation realisiert sein.

Eine besonders zu bevorzugende Variante ist die mit einer protonenimplantierten Zone bzw. Sperrstreifen 12. Hier ist in der Tiefe der Fläche 3 derartige Protonenimplantation vorhanden, d.h. mit der Protonenimplantation ist die der Fläche 3 entsprechende Strahlungsausbreitungsfläche erfaßt. In diese Zone 12 reinlaufende Superstrahlung 21 erfährt dort eine besonders hohe Absorption aufgrund der strahlungsabsorbierenden Störstellen.

Die Zonen 13 und 14 sind grabenförmige bzw. nutenförmige Einschnitte des Halbleiterkörpers 2 mit in einem Böschungswinkel geneigter Seitenwand 131 bzw. schwalbenschwanzförmig geneigter Seitenwand 141. Mit 21 bezeichnete Superstrahlung, die auf derartig geneigte Flächen 131 bzw. 141 auftrifft wird entweder in den Halbleiterkörper 2 (Fläche 131) oder entsprechendem Winkel aus diesem herausreflektiert (Fläche 141).

Die Aufrauhung der Oberfläche der rinnenartigen Vertiefung 15 des Halbleiterkörpers 2 streut Superstrahlung und insbesondere verhindert sie das Entstehen unerwünschter Schwingungsmoden 22 dadurch, daß die hier für an sich notwendige Rückreflexion in den Bereich der Gruppe a hinein wegfällt. Das gleiche gilt für die Aufrauhung 16.

Wie bereits oben erwähnt, sind alle Zonen so tief in den Halbleiterkörper 2 hineinreichend ausgebildet, daß die für das erfindungsgemäße Prinzip notwendige Trennung in die einzelnen Gruppen a, b, ... bewirkt ist. Es ist aber auch möglich, eine Ausführungsform der Erfindung so auszubilden, daß eine derartige Zone sich nicht über die ganze Länge der Laserdiodenstreifen 4 hinweg erstreckt, sondern daß wie z.B. zur Rinne 15 angedeutet, diese Rinne sich nur über einen wesentlichen Anteil der Länge der benachbarten Laserdiodenstreifen 4 erstreckt. Ein verbleibender restlicher Bereich kann dazu dienen, eine gewisse optische Kopplung (auch) zwischen benachbarten Gruppen (hier Gruppen a und b) aufrecht zu halten.

Bei der Erfindung vorgesehene Laserdiodenstreifen 4 haben z.B. eine Breite von 2 bis 4 μm. Sie sind z.B. innerhalb einer jeweiligen Gruppe in Abständen von 10 bis 20 μm angeordnet. Die Länge eines Laserdiodenstreifens beträgt z.B. 200 bis 440 μm. Bei mittleren Werten der spezifischen Verstärkung und der Güte des optischen Resonators kann eine jeweilige Gruppe etwa 20 bis 40 Laserdiodenstreifen 4 umfassen, ohne daß bereits die mit der Erfindung zu vermeidenden ansonsten für größere Anzahl von Laserdiodenstreifen eines Arrays auftretenden Nachteile auftreten, nämlich eine zu niedrige Grenze für maximale Strahlungsleistung und/oder ungünstig hoher elektrischer Leistungsaufwand für zu erhaltende Strahlungsleistung.

Die Erfindung ist sowohl für optisch gekoppelte Laserdiodenstreifen als auch für Arrays ohne derartige optische Kopplung zu verwenden.

**Patentansprüche**

1. Laserdioden-Array, mit einer Vielzahl in im

4

wesentlichen in einer Fläche in einem Halbleiterkörper im wesentlichen parallel zueinander, in Abständen voneinander, nebeneinander angeordneten einzelnen Laserdiodenstreifen mit jeweils einem optischen Resonator, so daß sich für dieses Array eine vorgegebene Emissionsrichtung der vorgesehenen Laserstrahlungsemission parallel zur Richtung der Anordnung der Laserdiodenstreifen ergibt, gekennzeichnet dadurch, daß zur Dämpfung von Superstrahlung (21) und/oder Strahlung mit Schwingungsmoden (22) mit von der vorgegebenen Emissionsrichtung (5) abweichenden Richtungen, die für das Array (1) vorgegebene Vielzahl der Laserdiodenstreifen (4) in Gruppen (a, b, c . . .) solcher Laserdiodenstreifen (4) aufgeteilt ist, wobei ine jeweilige Gruppe maximal nur eine so große Anzahl von Laserdiodenstreifen (4) umfaßt, daß die innerhalb des von einer solchen Gruppe eingenommenen Bereichs des Halbleiterkörpers (2) erzeugte Superstrahlung (21) und/oder erzeugte Strahlung mit Schwingungsmoden (22) mit gegenüber der für die vorgesehene Laserstrahlungsemission (5) der Gruppe abweichender Emissionsrichtung noch vernachlässigbar gehalten ist und daß jeweils eine im wesentlichen streifenförmige, sich im wesentlichen parallel zu den Laserdiodenstreifen (4) erstreckende, die Fläche (3) der Laserdiodenstreifen (4) des Arrays (1) erfassende Zone (11, 12, 13, 14, 15, 16) zwischen je zwei benachbarten Gruppen (a—b, b—c, c—d . . .) bzw. am Außenrand (16) einer am Ende des Arrays liegenden Gruppe (a) im bzw. am Halbleiterkörper (2) vorgesehen ist, die Dämpfungseigenschaft für Super- bzw. Laserstrahlung des Arrays (1) hat.

2. Array nach Anspruch 1, gekennzeichnet dadurch, daß die Zonen (15) grabenartige, die Strahlungsausbreitungsfläche (3) erfassende, sich im wesentlichen in Richtung und wenigstens zu einem wesentlichen Anteil entlang eines jeweils benachbarten Laserdiodenstreifens (4) erstreckende Vertiefungen (15) im Halbleiterkörper sind, deren den Gruppen (a, b) zugewandte Seitenwände eine für die Strahlung Streuung bewirkende Aufrauhung besitzen.

3. Array nach Anspruch 1 oder 2, gekennzeichnet, dadurch, daß für eine an Ende des Arrays liegende Gruppe (a) als deren außenliegende Zonen (16) die betreffende Seitenfläche des Halbleiterkörpers (2) wenigstens im Bereich der Strahlungsausbreitungsfläche (3) eine für die Strahlung Streuung bewirkende Aufrauhung besitzt.

4. Array nach Anspruch 1, 2 oder 3, gekennzeichnet dadurch, daß die Zonen (13, 14) einen die Strahlungsausbreitungsfläche (3) erfassenden Reflexionsstreifen (131, 141) haben, der sich im wesentlichen in Richtung und wenigstens zu einem wesentlichen Anteil entlang eines jeweils benachbarten Laserdiodenstreifens (14) erstreckt und dessen Reflexionsfläche so im Winkel ausgerichtet ist, daß auf den Reflexionsstreifen (131, 141) in der Strahlungsausbreitungsfläche (3) auffallende Superstrahlung (21) und/oder Strahlung von Schwingungsmoden (22) eine Ablenkung (121) erfährt.

5. Array nach einem der Ansprüche 1 bis 4, gekennzeichnet dadurch, daß die Zonen (11) die Strahlungsausbreitungsfläche (3) erfassend sich entlang einem jeweils benachbarten Laserdiodenstreifen (4) erstreckende Sperrstreifen (11) des Halbleiterkörpers (2) sind, in denen im Betrieb wenigstens wesentlich geringere elektrische Stromdichte vergleichsweise zur Stromdichte in den Laserdiodenstreifen (4) auftritt.

6. Array nach einem der Ansprüche 1 bis 5, gekennzeichnet dadurch, daß die Zonen (12) die Strahlungsausbreitungsfläche erfassende, sich entlang einem jeweils benachbarten Laserdiodenstreifen (4) erstreckende Sperrstreifen (12) des Halbleiterkörpers (2) sind, in denen des Halbleitermaterial protonenimplantiert ist.

7. Array gekennzeichnet dadurch, daß verschiedene Varianten von Zonen nach wenigstens zwei der Ansprüche 2 bis 6 in einem Array (1) vorhanden sind.

## Revendications

1. Réseau de diodes laser, comportant une multiplicité de bandes individuelles de diodes laser, disposées côte-à-côte, à distance les unes des autres, en étant sensiblement parallèles entre elles et situées sensiblement dans une surface à l'intérieur d'un corps semiconducteur, et comportant chacune un résonateur optique de sorte que l'on obtient, pour ce réseau, une direction prédéterminée de l'émission prévue du rayonnement laser, parallèlement à la direction de la disposition des bandes de diodes laser, caractérisé par le fait que pour l'amortissement du super-rayonnement (21) et/ou du rayonnement possédant des modes d'oscillation (22) correspondant à des directions s'écartant de la direction prédéterminée d'émission (5), la multiplicité, prévue pour le réseau (1), des bandes (4) de diodes laser est répartie en groupes (a, b, c, . . .) de telles bandes (4) de diodes laser, un groupe respectif comportant au maximum seulement un nombre suffisamment élevé de bandes (4) de diodes laser pour que le super-rayonnement (21) et/ou le rayonnement produit avec des modes l'oscillation (22) correspondant à une direction d'émission s'écartant de la direction prévue (5) du rayonnement laser du groupe, à l'intérieur de la zone du corps semiconducteur (2) occupée par un tel groupe, soit maintenu à une valeur encore négligeable et que respectivement une zone (11, 12, 13, 14, 15, 16) sensiblement en forme de bande, qui s'étend sensiblement parallèlement aux bandes (4) des diodes laser et dépasse le niveau de la surface (3) des bandes (4) de diodes laser du réseau (1) est prévue entre deux groupes voisins respectifs a—b, b—c, c—d . . .) on sur le bord extérieur (16) d'un groupe (a) situé à l'extrémité du réseau dans ou sur le corps semiconducteur (2) et possède la caractéristique d'affaiblissement pour le super-rayonnement ou le rayonnement laser du réseau (1).

2. Réseau suivant la revendication 1, caractérisé par le fait que les zones (15) sont des renfoncements (15) en forme de sillons ménagés dans le corps semiconducteur, qui dépassant le niveau de la surface (3) de propagation du rayonnement, s'étendent sensiblement dans la direction et au moins pour une part importante le long d'une bande respectivement voisine (4) de diodes laser et dont les parois latérales tournées vers les groupes (a, b) possèdent une rugosité de surface provoquant une diffusion du rayonnement.

3. Réseau suivant la revendication 1 ou 2, caractérisé par le fait que pour un groupe (a) situé à l'extrémité du réseau, la surface latérale considérée du corps semiconducteur (2) possède, en tant que zone extérieure (16) de ce groupe, une rugosité de surface provoquant une dispersion du rayonnement, au moins dans la zone de la surface (3) de propagation du rayonnement.

4. Réseau suivant la revendication 1, 2 ou 3, caractérisé par le fait que les zones (13, 14) possèdent une bande réfléchissante (131, 141) qui englobe la surface (3) de propagation du rayonnement, s'étend essentiellement dans la direction et au moins pour une part importante le long d'une bande respectivement voisine (4) de diodes laser et dont la surface réfléchissante est orientée selon un angle tel que le super-rayonnement (21) et/ou le rayonnement de modes d'oscillation (22), qui tombe sur les bandes réfléchissantes (131, 141) situées dans la surface (3) de propagation du rayonnement, est réduit (121).

5. Réseau suivant l'une des revendications 1 à 4, caractérisé par le fait que les zones (11) sont des bandes de blocage (11) du corps semiconducteur (2), qui s'étendent le long d'une bande respectivement voisine (4) de diodes laser en dépassant le niveau de la surface (3) de propagation du rayonnement et dans lesquelles apparaît, en fonctionnement, une densité de courant électrique au moins nettement plus faible que la densité de courant présente dans les bandes (4) de diodes laser.

6. Réseau suivant l'une des revendications 1 à 5, caractérisé par le fait que les zones (12) sont des bandes de blocage (12) du corps semiconducteur (2), qui dépassent le niveau de la surface de propagation du rayonnement, s'étendent le long d'une bande respectivement voisine (4) de diodes laser et au niveau desquelles des protons sont implantés dans le matériau semiconducteur.

7. Réseau caractérisé par le fait que différentes variantes de zones selon au moins deux des revendications 2 à 6 sont présentes dans un réseau (1).

## Claims

1. Laser diode array, having, essentially in one plane in a semiconductor body, a multiplicity of individual laser diode strips arranged next to one another, essentially parallel to one another and spaced from one another having in each case one optical resonator so that for this array a prescribed emission direction of the intended laser radiation emission is obtained parallel to the direction of the arrangement of the laser diode strips, characterized in that, for damping super radiation (21) and/or radiation with oscillatory modes (22) with directions deviating from the prescribed emission direction (5), the multiplicity of laser diode strips (4) prescribed for the array (1) is divided up into groups (a, b, c . . .) of such laser diode strips (4), a respective group comprising as a maximum only such a number of laser diode strips (4) that the super radiation (21) generated within the region of the semiconductor body (2) taken up by such a group and/or radiation generated with oscillatory modes (22) with emission direction deviating from that for the intended laser radiation emission (5) of the group is still kept negligible, and in that in each case one essentially strip-shaped zone (11, 12, 13, 14, 15, 16) which extends essentially parallel to the laser diode strips (4) and which covers the plane (3) of the laser diode strips (4) of the array (1) is provided between in each case two adjacent groups (a—b, b—c, c—d . . .) or on the outer edge (16) of a group (a), lying at the end of the array, in the or on the semiconductor body (2), said zone having a damping property for super or laser radiation of the array (1).

2. Array according to Claim 1, characterized in that the zones (15) are trough-like depressions in the semiconductor body (15) covering the radiation propagation plane (3) and extending essentially in the direction and at least along a substantial portion of the length of an in each case adjacent laser diode strip (4) the side-walls of said depressions facing the groups (a, b) having roughening which brings about scattering of the radiation.

3. Array according to Claim 1 or 2, characterized in that for a group (a) lying at the end of the array, as the outer zones (16) of said group, the relevant side face of the semiconductor body (2) has roughening at least in the region of the radiation propagation plane (3), which brings about scattering of the radiation.

4. Array according to Claim 1, 2 or 3, characterized in that the zones (13, 14) have a reflection strip (131, 141) covering the radiation propagation plane (3), said reflection strip extending essentially in the direction and at last along a substantial portion of the length of an in each case adjacent laser diode strip (4) and the reflection face of said laser diode strip being aligned at an angle in such a way that super radiation (21) impinging on the reflection strip (131, 141) in the radiation propagation plane (3) and/or radiation of oscillatory modes (22) experience deflection (121).

5. Array according to Claim 1 to 4, characterized in that the zones (11) are barrier strips (11) of the semiconductor body (2) which cover the radiation propagation plane (3) and extend along an in each case adjacent laser diode strip (4), an at least substantially lower electrical current density occurring in said barrier strips in operation in comparison with the current density in the laser diode strips (4).

6. Array according to Claim 1 to 5, characterized in that the zones (12) are barrier strips (12) of the semiconductor body (2) which cover the radiation propagation plane and extend along an in each case adjacent laser diode strip (4), the semiconductor material being proton implanted in said barrier strips.

7. Array, characterized in that various variants of zones according to at least two of the Claims 2 to 6 are present in one array (1).